# EUROPEAN PATENT APPLICATION

(11) **EP 4 036 994 A1**
(43) Date of publication of application: **03.08.2022**
(21) Application number: 22153272.4
(22) Date of filing: 25.01.2022
(51) Int. Cl.: H01L 33/50, H01L 33/46, H01L 25/075, H01L 33/00, H01L 33/58, H01L 33/60

(54) **WAVELENGTH CONVERSION MODULE, MANUFACTURING METHOD THEREOF, AND DISPLAY DEVICE INCLUDING SAID MODULE**

(30) Priority: 28.01.2021 CN 202110115878
(71) Applicant: Coretronic Corporation, Hsin-Chu 300 (TW)
(72) Inventor: TSAI, MING-WEI, 300 Hsin-Chu (TW); HUANG, YU-AN, 300 Hsin-Chu (TW); CHUANG, FU-MING, 300 Hsin-Chu (TW)
(74) Representative: Ter Meer Steinmeister & Partner

(57) **Abstract**

A wavelength conversion module (200) including an isolation structure layer (210), multiple wavelength conversion patterns (WCP1, WCP2), a dichroic filter film (220), and at least one dichroic filter layer (230) is provided. The isolation structure layer has multiple openings (OP). The wavelength conversion patterns are disposed in a part of the openings, and configured to absorb a first part of multiple excitation light beams (LBe) to generate multiple converted light beams (LBc). The dichroic filter film is disposed on one side of the isolation structure layer. The at least one dichroic filter layer is disposed on another side of the isolation structure layer or disposed in the openings. A part of the converted light beams are reflected back to the wavelength conversion patterns by the dichroic filter film. A second part of the excitation light beams, passing through the wavelength conversion patterns, are reflected back to the wavelength conversion patterns by the at least one dichroic filter layer.

## Description

This application claims the priority of China application serial no. 202110115878.x, filed on January 28, 2021.

### BACKGROUND

### Technical Field

The invention relates to a light-emitting device, an optical module, and a manufacturing method thereof, and particularly relates to a display device, a wavelength conversion module, and a manufacturing method thereof.

### Description of Related Art

In recent years, as manufacturing costs of organic light-emitting diode (OLED) display panels are getting high while its service lives cannot compete with current mainstream displays, micro LED displays have come to attract investment attentions of major technology companies. The micro LED displays have the same optical performance as that of the OLED displays, such as high color saturation, fast response speed, and high contrast, and have the advantages of low energy consumption and long material life. Generally, the manufacturing technology of the micro LED display adopts a die transposition method to transfer pre-made micro LED dies directly to a driving circuit back plate, which is the so-called mass transfer technology. However, this mass transfer technology cannot be applied effectively to the production of full-color micro LED displays with a pixel size less than 5 µm.

In order to meet the product requirements, a technical solution that uses a micro LED element array of a single-color light (such as blue light) to excite a wavelength conversion material (such as nanophosphor or a quantum dot material) to form a variety of required color light has been proposed. However, such technical solution has the problem of low light conversion efficiency, and its excitation light beams cannot be fully absorbed such that there is still emission (for example, blue light leakage) accompanying the converted light beams, resulting in insufficient color purity of light color.

The information disclosed in this Background section is only for enhancement of understanding of the background of the described technology and therefore it may contain information that does not form the prior art that is already known to a person of ordinary skill in the art. Further, the information disclosed in the Background section does not mean that one or more problems to be resolved by one or more embodiments of the invention were acknowledged by a person of ordinary skill in the art.

### SUMMARY

It is an object of the present invention to provide a wavelength conversion module, which has good light output efficiency.

It is an object of the present invention to provide a display device, which has high color purity in output light color.

It is an object of the present invention to provide a manufacturing method of a wavelength conversion module, where a produced dichroic filter layer ensures that light emitted by the wavelength conversion module from a plurality of openings of an isolation structure layer has good color purity.

The objects are solved by the features of the independent claims. Preferred embodiments are given in the dependent claims.

In order to achieve one or a portion of or all of the objects or other objects, an embodiment of the invention provides a wavelength conversion module. The wavelength conversion module includes an isolation structure layer, a plurality of wavelength conversion patterns, a dichroic filter film, and at least one dichroic filter layer. The isolation structure layer has a first surface and a second surface opposite to each other, and a plurality of openings penetrating the first surface and the second surface. The wavelength conversion patterns are respectively disposed in a part of the openings. The wavelength conversion patterns are configured to absorb a first part of a plurality of excitation light beams and be excited to generate a plurality of converted light beams. The dichroic filter film is disposed on a side of the first surface of the isolation structure layer and is overlapped with the wavelength conversion patterns. The at least one dichroic filter layer is disposed on a side of the second surface of the isolation structure layer or disposed in the openings, and is overlapped with the wavelength conversion patterns. A part of the converted light beams are reflected back to the wavelength conversion patterns by the dichroic filter film, and a second part of the excitation light beams passing through the wavelength conversion patterns are reflected back to the wavelength conversion patterns by the at least one dichroic filter layer.

In order to achieve one or a portion of or all of the objects or other objects, an embodiment of the invention provides a manufacturing method of a wavelength conversion module. The manufacturing method of the wavelength conversion module includes forming a plurality of dichroic filter layers separated from each other on a light-transmitting substrate; forming a plurality of wavelength conversion patterns separated from each other; forming a plurality of light-transmitting patterns; and forming an isolation structure layer between the light-transmitting patterns and the wavelength conversion patterns. The wavelength conversion patterns are completely overlapped with the dichroic filter layers. The wavelength conversion patterns and the light-transmitting patterns are arranged in alternation and separated from each other.

In order to achieve one or a portion of or all of the objects or other objects, an embodiment of the invention provides a display device. The display device includes a light source module and a wavelength conversion module. The light source module includes a substrate and a plurality of light-emitting diode elements. The light-emitting diode elements are disposed on the substrate, and are configured to provide a plurality of excitation light beams. The wavelength conversion module is overlapped and arranged on the light source module, and includes an isolation structure layer, a plurality of wavelength conversion patterns, a dichroic filter film, and at least one dichroic filter layer. The isolation structure layer has a first surface and a second surface opposite to each other, and a plurality of openings penetrating the first surface and the second surface, and the light-emitting diode elements are respectively overlapped with the openings. The wavelength conversion patterns are respectively disposed in a part of the openings. The wavelength conversion patterns are configured to absorb a first part of the excitation light beams and be excited to generate a plurality of converted light beams. The dichroic filter film is disposed on a side of the first surface of the isolation structure layer and is overlapped with the wavelength conversion patterns. The at least one dichroic filter layer is disposed on a side of the second surface of the isolation structure layer or disposed in the openings, and is overlapped with the wavelength conversion patterns. A part of the converted light beams are reflected back to the wavelength conversion patterns by the dichroic filter film, and a second part of the excitation light beams passing through the wavelength conversion patterns are reflected back to the wavelength conversion patterns by the at least one dichroic filter layer.

In one or more embodiments, a number of the at least one dichroic filter layer may be one.

The dichroic filter layer may be disposed on the side of the second surface of the isolation structure layer

The wavelength conversion module may further comprise a plurality of light-transmitting patterns

The light-transmitting patterns may be respectively disposed in another part of the openings.

The dichroic filter layer may comprise a light-transmitting region overlapped with the light-transmitting patterns.

The dichroic filter layer may comprise a third part of the excitation light beams passing through the light-transmitting patterns directly pass through the light-transmitting region of the dichroic filter layer.

In one or more embodiments, the wavelength conversion module may further comprise a blocking layer.

The blocking layer may be disposed between the dichroic filter layer and the isolation structure layer.

The blocking layer may directly contact the wavelength conversion patterns and the dichroic filter layer.

In one or more embodiments, wavelength conversion module may further comprise a light-transmitting substrate.

The light-transmitting substrate may be disposed between the wavelength conversion patterns and the dichroic filter layer.

In one or more embodiments, wavelength conversion module may further comprise an adhesive layer.

The adhesive layer may connect the light-transmitting substrate and the second surface of the isolation structure layer.

In one or more embodiments, the openings may comprise a plurality of first openings and a plurality of second openings.

The first openings and the second openings may be arranged in alternation.

Each of the first openings may comprise a plurality of first sub-openings located on the first surface and a second sub-opening located on the second surface.

The second sub-opening may communicate with the first sub-openings.

The wavelength conversion patterns may be respectively disposed in the first sub-openings.

The wavelength conversion module may further comprise a plurality of light-transmitting patterns.

The light-transmitting patterns may be respectively disposed in the second openings and configured to allow a third part of the excitation light beams to pass through.

A number of the at least one dichroic filter layer may be pural.

The dichroic filter layers may be respectively disposed in the second sub-openings of the first openings.

In one or more embodiments, a wavelength of the part of the converted light beams reflected by the dichroic filter film may be between 475 nm and 700 nm.

In one or more embodiments, a wavelength of the second part of the excitation light beams reflected by the at least one dichroic filter layer may be less than 500 nm.

In one or more embodiments, after the excitation light beams pass through the dichroic filter film, a divergence angle of the excitation light beams may be changed from a first angle to a second angle, and the second angle is smaller than the first angle.

In one or more embodiments, the second angle may be smaller than or equal to 90 degrees.

In one or more embodiments, a material of the isolation structure layer may comprise a light-absorbing material, a metal material with high reflectivity, or a non-metal material with high reflectivity.

In one or more embodiments, the wavelength conversion module may further comprise a light-transmitting substrate.

The light-transmitting substrate may be disposed on the side of the second surface of the isolation structure layer.

In one or more embodiments, the wavelength conversion module may further comprise a plurality of optical microstructures.

The optical microstructures may be disposed on a side surface of the light-transmitting substrate that is away from the isolation structure layer.

The wavelength conversion patterns may be overlapped with the optical microstructures.

In one or more embodiments, the method may further comprise forming a dichroic filter film.

The dichroic filter film may be located on a side of the isolation structure layer that is away from the light-transmitting substrate.

In one or more embodiments, the method may further comprise forming an intermediate layer on the side of the isolation structure layer that is away from the light-transmitting substrate.

The intermediate layer may be located between the isolation structure layer and the dichroic filter film.

In one or more embodiments, the display device may further comprise a transparent conductive film.

The transparent conductive film may comprise a substrate material and a conductive material layer.

The conductive material layer may be disposed between the substrate material and the light source module.

In one or more embodiments, the substrate of the light source module may be configured with a plurality of conductive patterns.

The light-emitting diode elements may be respectively electrically connected between one of the conductive patterns and the conductive material layer

The wavelength conversion module may be attached to the substrate material of the transparent conductive film.

In one or more embodiments, a number of the at least one dichroic filter layer may be one.

The dichroic filter layer may be disposed on the side of the second surface of the isolation structure layer.

The wavelength conversion module may further comprise a plurality of light-transmitting patterns.

The light-transmitting patterns may be respectively disposed in another part of the openings.

The dichroic filter layer may comprise a light-transmitting region overlapped with the light-transmitting patterns and a third part of the excitation light beams passing through the light-transmitting patterns directly pass through the light-transmitting region of the dichroic filter layer.

In one or more embodiments, the display device may further comprise a blocking layer, disposed between the dichroic filter layer and the isolation structure layer, and directly contacting the wavelength conversion patterns and the dichroic filter layer.

In one or more embodiments, the display device may further comprise a light-transmitting substrate, disposed between the wavelength conversion patterns and the dichroic filter layer; and an adhesive layer, connecting the light-transmitting substrate and the second surface of the isolation structure layer.

In one or more embodiments, the openings may comprise a plurality of first openings and a plurality of second openings.

The first openings and the second openings may be arranged in alternation.

Each of the first openings may comprise a plurality of first sub-openings located on the first surface and a second sub-opening located on the second surface, the second sub-opening communicates with the first sub-openings.

The wavelength conversion patterns may be respectively disposed in the first sub-openings.

The wavelength conversion module may further comprise a plurality of light-transmitting patterns.

The light-transmitting patterns may be respectively disposed in the second openings and configured to allow a third part of the excitation light beams to pass through.

A number of the at least one dichroic filter layer is plural.

The dichroic filter layers may be respectively disposed in the second sub-openings of the first openings.

In one or more embodiments, the display device may further comprise a light-transmitting substrate, disposed on the side of the second surface of the isolation structure layer; and a plurality of optical microstructures, disposed on a side surface of the light-transmitting substrate that is away from the isolation structure layer, wherein the wavelength conversion patterns are overlapped with the optical microstructures.

In one or more embodiments, the light source module may further comprise a plurality of optical microstructures, respectively covering the light-emitting diode elements and located between the light-emitting diode elements and the dichroic filter film.

In one or more embodiments, a divergence angle of the excitation light beams after passing through the optical microstructures may be less than or equal to 60 degrees.

Based on the above description, in the wavelength conversion module and the display device of an embodiment of the invention, the dichroic filter layer disposed on one side of the wavelength conversion patterns is used to reflect the excitation light beam passing through the wavelength conversion patterns back to the wavelength conversion patterns, and the dichroic filter film disposed on the other side of the wavelength conversion patterns is used to reflect the converted light beams coming from the wavelength conversion patterns back to the wavelength conversion patterns. In this way, the light output efficiency and conversion efficiency of the wavelength conversion module are improved. In addition, the permeability of the dichroic filter layer to the converted light beams and the reflectivity thereof to the excitation light beams may also effectively improve a color purity of display colors of the display device. In the manufacturing method of the wavelength conversion module of an embodiment of the invention, the isolation structure layer is formed after formation of the wavelength conversion patterns, the dichroic filter layer and the light-transmitting patterns. Therefore, the wavelength conversion patterns (or dichroic filter layers) and the light-transmitting patterns arranged at intervals may be separated by the subsequently formed isolation structure layer, thereby improving light output concentration of each opening and the display quality (such as image clarity) of the display device.

To make the aforementioned more comprehensible, several embodiments accompanied with drawings are described in detail as follows.

Other objectives, features and advantages of the invention will be further understood from the further technological features disclosed by the embodiments of the invention wherein there are shown and described preferred embodiments of this invention, simply by way of illustration of modes best suited to carry out the invention.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG.1 schematic sectional view of a part of a display device of a 1^{st} embodiment of the invention.
FIG.2 is an enlarged schematic diagram of a partial area of the display device of FIG. 1.
FIG.3 is a curve relationship diagram of transmittances of a dichroic filter film of FIG.1 relative to incident angles.
FIG.4 relationship diagram of transmittances of the dichroic filter film in FIG.1 to wavelengths.
FIG. 5 relationship diagram of transmittances of a dichroic filter layer of FIG.1 to wavelengths.
FIG.6 schematic sectional view of a part of a display device of a 2^{nd} embodiment of the invention.
FIG.7 schematic sectional view of a part of a display device of a 3^{rd} embodiment of the invention.
FIG.8 is a schematic cross-sectional view of a part of a display device of a 4^{th} of the invention.
FIG.9A to 9F are schematic diagrams of a manufacturing process of a wavelength conversion module of FIG.8.
FIG. 10 is a schematic sectional view of a part of a display device of a 5^{th} embodiment.
FIG. 11 is a schematic cross-sectional view of a part of a display device of a 6^{th} embodiment.

### DESCRIPTION OF THE EMBODIMENTS

In the following detailed description of the preferred embodiments, reference is made to the accompanying drawings which form a part hereof, and in which are shown by way of illustration specific embodiments in which the invention may be practiced. In this regard, directional terminology, such as "top," "bottom," "front," "back," etc., is used with reference to the orientation of the Figure(s) being described. The components of the invention can be positioned in a number of different orientations. As such, the directional terminology is used for purposes of illustration and is in no way limiting. On the other hand, the drawings are only schematic and the sizes of components may be exaggerated for clarity. It is to be understood that other embodiments may be utilized and structural changes may be made without departing from the scope of the invention. Also, it is to be understood that the phraseology and terminology used herein are for the purpose of description and should not be regarded as limiting. The use of "including," "comprising," or "having" and variations thereof herein is meant to encompass the items listed thereafter and equivalents thereof as well as additional items. Unless limited otherwise, the terms "connected," "coupled," and "mounted" and variations thereof herein are used broadly and encompass direct and indirect connections, couplings, and mountings. Similarly, the terms "facing," "faces" and variations thereof herein are used broadly and encompass direct and indirect facing, and "adjacent to" and variations thereof herein are used broadly and encompass directly and indirectly "adjacent to". Therefore, the description of "A" component facing "B" component herein may contain the situations that "A" component directly faces "B" component or one or more additional components are between "A" component and "B" component. Also, the description of "A" component "adjacent to" "B" component herein may contain the situations that "A" component is directly "adjacent to" "B" component or one or more additional components are between "A" component and "B" component. Accordingly, the drawings and descriptions will be regarded as illustrative in nature and not as restrictive.

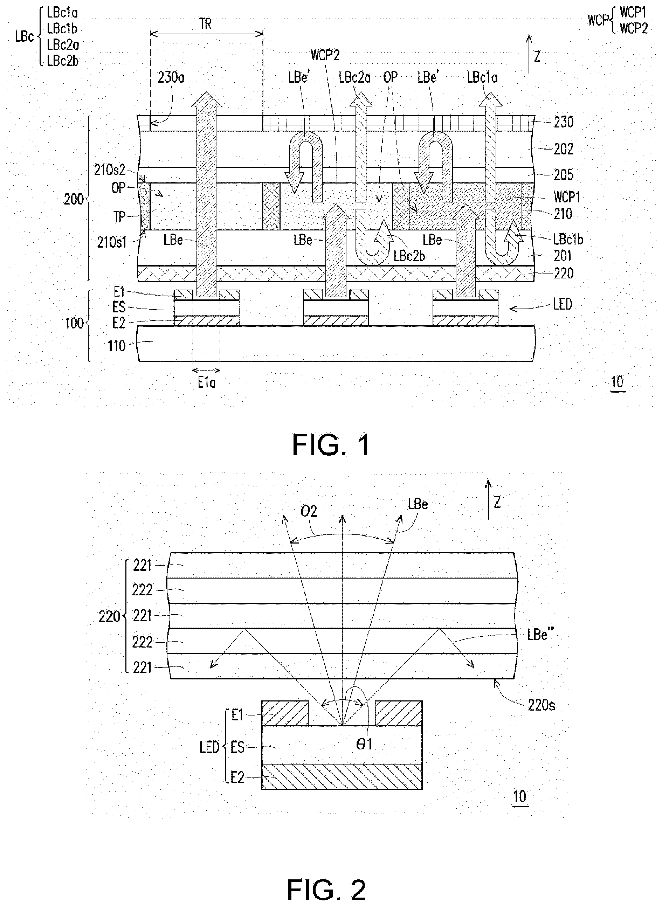

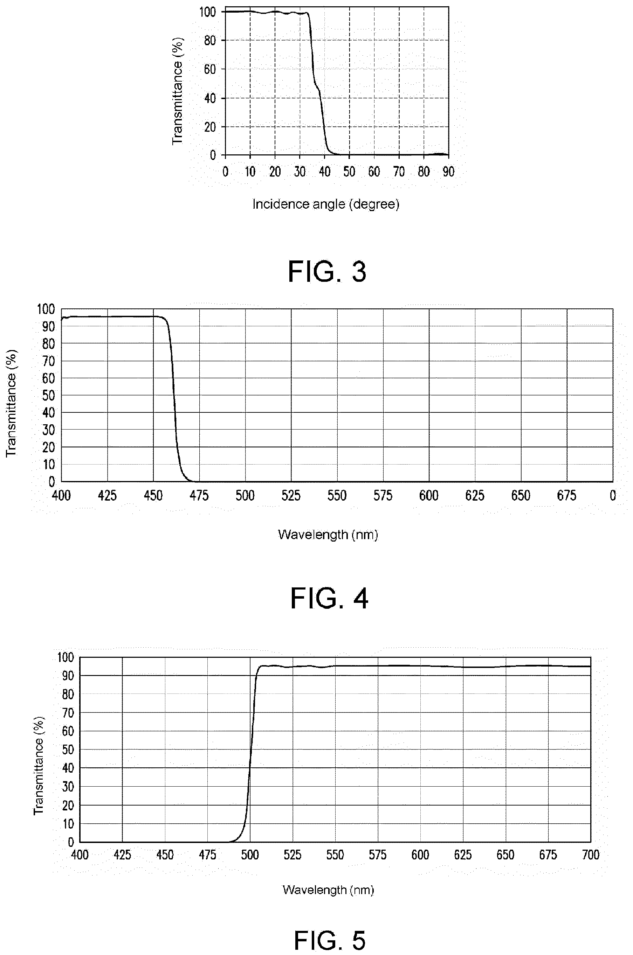

FIG.1 is a schematic cross-sectional view of a part of a display device according to a first embodiment of the invention. FIG.2 is an enlarged schematic diagram of a partial area of the display device of FIG.1. FIG.3 is a curve relationship diagram of transmittances of a dichroic filter film of FIG.1 relative to incident angles. FIG.4 is a curve relationship diagram of transmittances of the dichroic filter film of FIG.1 relative to wavelengths. FIG.5 is a curve relationship diagram of transmittances of a dichroic filter layer of FIG.1 relative to wavelengths.

Referring to FIG.1, the display device 10 includes a light source module 100 and a wavelength conversion module 200. The wavelength conversion module 200 is overlapped and arranged on the light source module 100. The light source module 100 includes a substrate 110 and a plurality of light-emitting diode elements LED. The light-emitting diode elements LED may be arranged on the substrate 110 in an array, and used to provide a plurality of excitation light beams LBe. In the embodiment, the substrate 110 may include a pixel circuit layer, and the pixel circuit layer is used to individually drive the light-emitting diode elements LED to emit the multiple excitation light beams LBe. Namely, respective light intensities of the excitation light beams LBe from the light-emitting diode elements LED may be independently controlled to generate an image frame to be displayed by the display device 10.

For example, in the embodiment, the light-emitting diode element LED has an epitaxial structure ES and a first electrode E1 and a second electrode E2 disposed on two opposite sides of the epitaxial structure ES. Namely, the light-emitting diode element LED of the embodiment may be a vertical type (micro light-emitting diode, micro LED), but the invention is not limited thereto. In other embodiments, the light-emitting diode element LED may also be a lateral type micro LED or a flip-chip type micro LED.

In the embodiment, a material of the first electrode E1 and the second electrode E2 is, for example, metal such as gold, silver, copper, tin, lead, hafnium, tungsten, molybdenum, neodymium, titanium, tantalum, aluminum, or zinc, or alloys thereof. Therefore, the first electrode E1 of the embodiment has a light-transmitting area E1a for emitting the excitation light beam LBe. However, the invention is not limited thereto. In other embodiments, the first electrode may also be a light-transmitting electrode, and a material of the light-transmitting electrode may include metal oxide, such as indium tin oxide, indium zinc oxide, aluminum tin oxide, aluminum zinc oxide, or other suitable oxides, or a stacked layer of at least two of the above materials.

The wavelength conversion module 200 includes an isolation structure layer 210 and a plurality of wavelength conversion patterns WCP. The isolation structure layer 210 has a first surface 210s1 and a second surface 210s2 opposite to each other, and a plurality of openings OP penetrating the first surface 210s1 and the second surface 210s2. The first surface 210s1 of the isolation structure layer 210 faces the light source module 100. E.g., the wavelength conversion patterns WCP include a plurality of red light wavelength conversion patterns WCP1 and a plurality of green light wavelength conversion patterns WCP2 respectively arranged in alternation in a part of the openings OP, but the invention is not limited thereto. A material of the wavelength conversion pattern WCP is, for example, a quantum dot material or nanophosphor. The wavelength conversion patterns WCP are used to absorb at least a part (ie.a first part) of the multiple excitation light beams LBe coming from the light source module 100 and be excited to generate a plurality of converted light beams LBc. In addition, another part of excitation light beams LBe' in the multiple excitation light beams LBe coming from the light source module 100 pass through the wavelength conversion patterns WCP, and cannot be effectively absorbed by the wavelength conversion patterns WCP, and such part of the excitation light beams LBe' are defined as a second part of the multiple excitation light beams LBe coming from the light source module 100.

It should be noted that the wavelength conversion module 200 may further include a light-transmitting substrate 201, the isolation structure layer 210 is disposed on the light-transmitting substrate 201, and the openings OP of the isolation structure layer 210 may be arranged on the light-transmitting substrate 201 in an array, and define a plurality of display pixel regions of the display device 10. In order to achieve a color display effect, the light beams from the display pixel regions may respectively have a plurality of display colors (for example, red, green, and blue). For example, in the embodiment, after the red light wavelength conversion pattern WCP1 absorbs a part of the excitation light beams LBe coming from the light source module 100 and is excited, a plurality of red converted light beams (for example, a converted light beam LBc 1a and a converted light beam LBc1b respectively emitted toward two opposite sides of the isolation structure layer 210) are generated. After the green light wavelength conversion pattern WCP2 absorbs a part of the excitation light beams LBe coming from the light source module 100 and is excited, a plurality of green converted light beams (for example, a converted light beam LBc2a and a converted light beam LBc2b respectively emitted toward two opposite sides of the isolation structure layer 210) are generated. Moreover, the wavelength conversion module 200 further includes a plurality of light-transmitting patterns TP, and the light-transmitting patterns TP are respectively disposed in another part of the openings OP, and a part of the excitation light beams LBe coming from the light source module 100 (i.e., a third part of the multiple excitation light beams LBe coming from the light source module 100) may directly pass through the light-transmitting patterns TP to serve as blue light for display. In the embodiment, a material of the light-transmitting pattern TP is, for example, a photoresist material or an optical adhesive material that allows the excitation light beam LBe to directly pass through, but the invention is not limited thereto. In other embodiments, the openings OP provided with the light-transmitting patterns TP in the isolation structure layer 210 may also be cavities without any components.

Specifically, three openings OP arranged adjacently and respectively provided with the red light wavelength conversion pattern WCP1, the green light wavelength conversion pattern WCP2 and the light-transmitting pattern TP may define a pixel unit of the display device 10, and a display color of the pixel unit depends on a proportional relationship of a light intensity of the red converted light beam from the red light wavelength conversion pattern WCP1, a light intensity of the green converted light beam from the green light wavelength conversion pattern WCP2, and a light intensity of the blue excitation light beam from the light-transmitting pattern TP.

In the embodiment, a material of the isolation structure layer 210 may include black resin, white resin, or other suitable light-absorbing materials or reflective materials, but the invention is not limited thereto. Therefore, the converted light beam LBc or the excitation light beam LBe with a larger included angle between a light path and a normal direction (for example, a direction Z) of the first surface 210s1 of the isolation structure layer 210 is easily absorbed or reflected by the isolation structure layer 210. Therefore, the light output concentration of each display pixel region (or the opening OP) may be effectively improved, so as to improve the display quality (such as image clarity).

It should be noted that in the embodiment, the light-emitting diode elements LED used for providing the excitation light beams LBe are, for example, blue LEDs, and a light-emitting wavelength thereof is, for example, within a range between 430 nm and 480 nm. Although a part of the excitation light beams LBe from the light source module 100 of the embodiment may be directly used as blue light for display, in other embodiments, in order to improve the color purity of blue light (i.e., to reduce a distribution range of a blue light wavelength) or to obtain the blue light in case that other light sources are used, the wavelength conversion modules of the other embodiments may choose to set blue light wavelength conversion patterns to obtain the required blue light.

Further, the wavelength conversion module 200 further includes a dichroic filter film 220 that is overlapped and arranged on the plurality of wavelength conversion patterns WCP. The dichroic filter film 220 is disposed on a side of the first surface 210s1 of the isolation structure layer 210, and the light-transmitting substrate 201 is located between the isolation structure layer 210 and the dichroic filter film 220. Namely, the dichroic filter film 220 is disposed on a side of the light-transmitting substrate 201 away from the isolation structure layer 210 and faces the light source module 100. Referring to FIG.2 at the same time, the dichroic filter film 220 may be a stacked structure of a plurality of dielectric layers. The dielectric layers, for example, include a plurality of high dielectric constant layers 221 and a plurality of low dielectric constant layers 222, and the high dielectric constant layers 221 and the low dielectric constant layers 222 are alternately stacked to form the aforementioned stacked structure. A material of the high dielectric constant layer 221 is, for example, titanium dioxide (TiO₂), and a material of the low dielectric constant layer 222 is, for example, silicon dioxide (SiO₂), but the invention is not limited thereto.

Particularly, a transmittance of a light beam (for example, the excitation light beam LBe) after passing through the aforementioned dichroic filter film 220 is dependent on an incident angle (as shown in FIG.3) of the light beam. For example, in the embodiment, in the multiple excitation light beams coming from the light-emitting diode elements LED of the light source module 100, an excitation light beam LBe" with an included angle (incident angle) between the light path and a normal direction (for example, the direction Z) of a surface 220s of the dichroic filter film 220 greater than 45 degrees may be reflected by the dichroic filter film 220 and cannot pass through, and the excitation light beam LBe with the included angle between the light path and the normal direction (for example, the direction Z) of the surface 220s of the dichroic filter film 220 smaller than 45 degrees (for example, 30 degrees) may pass through the dichroic filter film 220. Therefore, after the excitation light beams coming from the light-emitting diode elements LED pass through the dichroic filter film 220, a divergence angle thereof may be changed from a first angle θ1 to a second angle θ2, and the second angle θ2 is smaller than the first angle θ1. In other words, the dichroic filter film 220 has the effect of reducing the divergence angle of the light beams, and accordingly, the light output efficiency of the light source module 100 may be improved. In a preferred embodiment, the second angle θ2 is less than or equal to 90 degrees.

Since the excitation light beams LBe coming from the light source module 100 must pass through the dichroic filter film 220 before being transmitted to the wavelength conversion patterns WCP, the dichroic filter film 220 of the embodiment should have a relatively high transmittance (as shown in FIG.4) in at least a part of a light-emitting wavelength range (for example, 430 nm to 460 nm) of the aforementioned light-emitting diode elements LED. Particularly, in the embodiment, the light beams with a wavelength range between 475 nm and 700 nm may be reflected by the dichroic filter film 220. In other words, the transmittance of the dichroic filter film 220 for the light beams with the wavelength ranging from 475 nm to 700 nm is approximately 0%.

For example, a part of the converted light beams LBc may be reflected back to the wavelength conversion patterns WCP by the dichroic filter film 220. To be specific, in the multiple converted light beams LBc generated after the wavelength conversion patterns WCP absorb the excitation light beams LBe and are excited, the converted light beams (for example, the red converted light beam LBclb and the green converted light beam LBc2b) transmitted toward the light source module 100 may be reflected back to the wavelength conversion patterns WCP by the dichroic filter film 220 and emit from the side of the second surface 210s2 of the isolation structure layer 210, thereby improving the light output efficiency of the wavelength conversion module 200.

Further, the wavelength conversion module 200 further includes a dichroic filter layer 230 that is overlapped and arranged on the plurality of wavelength conversion patterns WCP, and the dichroic filter layer 230 is located on the side of the second surface 210s2 of the isolation structure layer 210. In the embodiment, the wavelength conversion module 200 may also selectively include another light-transmitting substrate 202 and an adhesive layer 205. The light-transmitting substrate 202 is disposed between the plurality of wavelength conversion patterns WCP and the dichroic filter layer 230, and the adhesive layer 205 connects the light-transmitting substrate 202 and the second surface 210s2 of the isolation structure layer 210, but the invention is not limited thereto. Namely, the dichroic filter layer 230 may be first formed on the transparent substrate 202, and is then attached to the second surface 210s2 of the isolation structure layer 210 via the adhesive layer 205.

It should be noted that the dichroic filter layer 230 has an obvious reflection effect for light beams with a wavelength less than 500 nm. Namely, a transmittance of the dichroic filter layer 230 to light beams with a wavelength less than 500 nn is less than 50% (as shown in FIG.5). On the contrary, the transmittance of the dichroic filter layer 230 for both green light and red light is greater than 90%. Therefore, for example, the second part LBe' of the excitation light beams LBe passing through the wavelength conversion patterns WCP may be reflected back to the wavelength conversion patterns WCP by the dichroic filter layer 230. To be specific, a part of the excitation light beams LBe' (i.e., the second part of the multiple excitation light beams LBe coming from the light source module 100) that cannot be effectively absorbed by the wavelength conversion patterns WCP may be reflected back to the wavelength conversion patterns WCP by the dichroic filter layer 230, which helps improving the conversion efficiency of the wavelength conversion module 200.

In the embodiment, the dichroic filter layer 230 has openings 230a overlapped with the light-transmitting patterns TP in the direction Z, and the openings 230a may define light-transmitting regions TR of the dichroic filter layer 230. A part of the excitation light beams LBe coming from the light source module 100 (i.e., the third part of the multiple excitation light beams LBe coming from the light source module 100) may directly pass through the light-transmitting regions TR without being reflected by the dichroic filter layer 230 after passing through the light-transmitting patterns TP. Namely, the light beams of the display device 10 used for displaying the blue color are the third part of the excitation light beams LBe passing through the light-transmitting patterns TP.

In overall, in the embodiment, the dichroic filter film 220 disposed between the isolation structure layer 210 and the light source module 100 may reflect a part of the converted light beams coming from the wavelength conversion patterns WCP (for example, the red converted light beam LBclb and the green converted light beam LBc2b) back to the wavelength conversion patterns WCP, so as to improve the light output efficiency of the wavelength conversion module 200. The dichroic filter layer 230 disposed on the side of the isolation structure layer 210 away from the light source module 100 may reflect a part of the excitation light beams that pass through the wavelength conversion patterns WCP and are not absorbed by the same back to the wavelength conversion patterns WCP, so as to improve the conversion efficiency of the wavelength conversion module 200. In addition, the permeability of the dichroic filter layer 230 to the converted light beams LBc and the reflectivity thereof to the excitation light beams may also effectively improve a color purity of display colors of the display device 10.

Other embodiments are provided below to describe the invention in detail, where the same components are denoted by the same referential numbers, and the description of the same technical content will be omitted. The aforementioned embodiment may be referred for descriptions of the omitted parts, and detailed descriptions thereof are not repeated in the following embodiment.

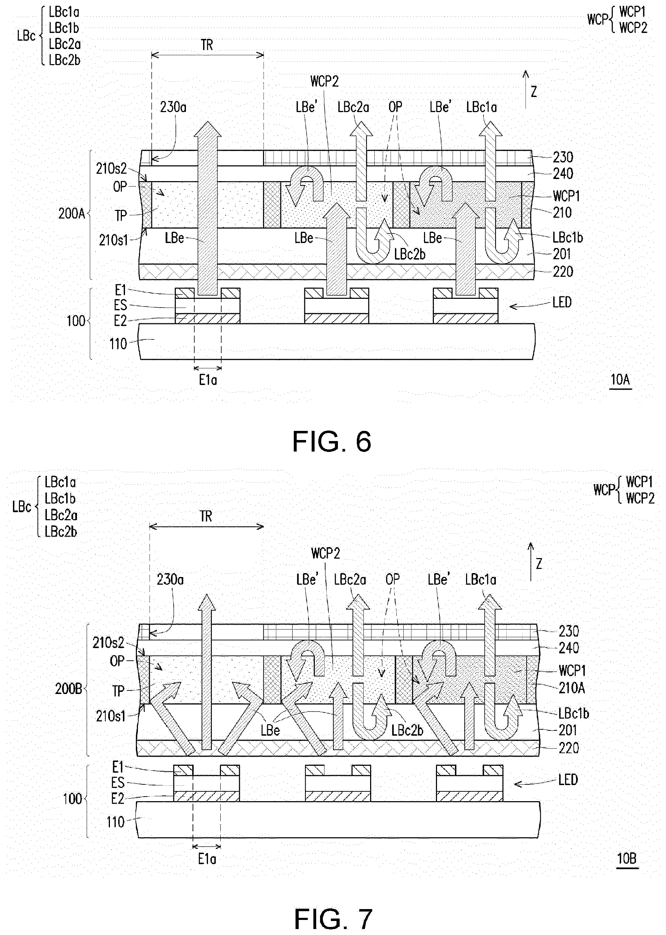

FIG.6 is a schematic cross-sectional view of a part of a display device according to a second embodiment of the invention. Referring to FIG.6, a difference between a display device 10A of the embodiment and the display device 10 of FIG.1 lies in different compositions of the wavelength conversion module. To be specific, a wavelength conversion module 200A of the display device 10A does not have the light-transmitting substrate 202 and the adhesive layer 205 as shown in FIG.1. Therefore, an overall thickness of the display device 10A may be further reduced. In order to avoid being affected by the structure of the wavelength conversion patterns WCP or the isolation structure layer 210 during film formation of the dichroic filter layer 230, a blocking layer 240 is provided between the dichroic filter layer 230 and the isolation structure layer 210 of the wavelength conversion module 200A, and the blocking layer 240 directly contacts the multiple wavelength conversion patterns WCP (for example, the red light wavelength conversion patterns WCP1 and the green light wavelength conversion patterns WCP2) and the dichroic filter layer 230.

FIG.7 is a schematic cross-sectional view of a part of a display device according to a third embodiment of the invention. Referring to FIG.7, a difference between a display device 10B of the embodiment and the display device 10A of FIG.6 is that a material of an isolation structure layer 210A of a wavelength conversion module 200B of the embodiment is a metal material with high reflectivity. Accordingly, a light energy utilization rate of the excitation light beam LBe and the conversion efficiency of the wavelength conversion module 200B may be further improved. In other embodiments, the material of the isolation structure layer 210A of the wavelength conversion module 200B may also be a non-metallic material with high reflectivity.

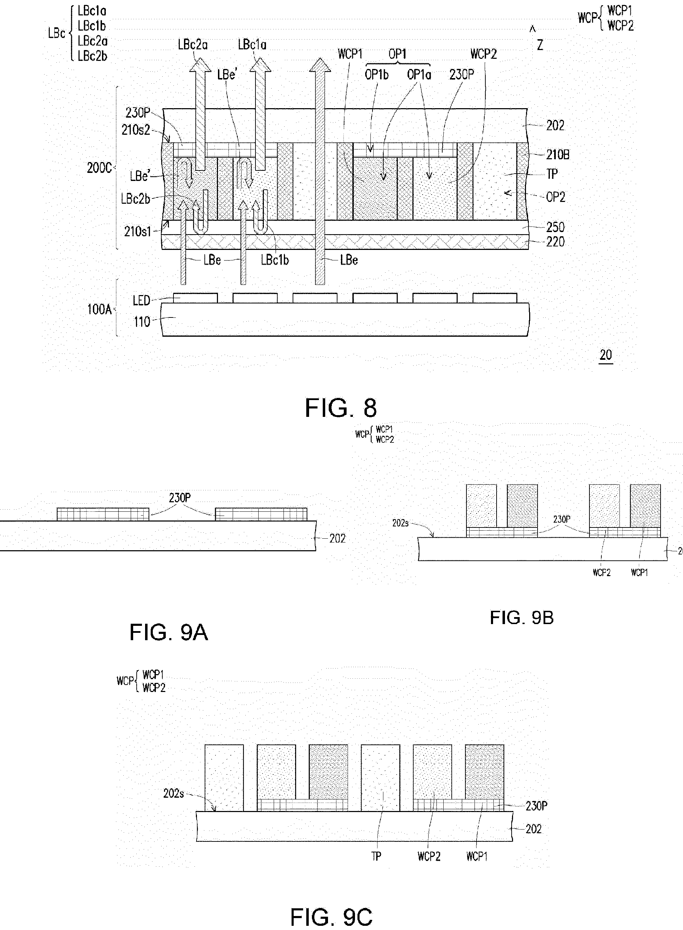

FIG.8 is a schematic cross-sectional view of a part of a display device according to a fourth embodiment of the invention. FIG.9A to 9F are schematic diagrams of a manufacturing process of a wavelength conversion module of FIG.8, which are presented in partial cross-sectional views of the wavelength conversion module. Referring to FIG.8, a main difference between a display device 20 of the embodiment and the display device 10A of FIG.6 lies in different structures of the dichroic filter layer and the isolation structure layer. In the embodiment, the plurality of openings of the isolation structure layer 210B may include a plurality of first openings OP1 and a plurality of second openings OP2. The first openings OP1 and the second openings OP2 are arranged in alternation. The first opening OP1 has a plurality of first sub-openings OP1a on the first surface 210s1 and a second sub-opening OP1b on the second surface 210s2, and the second sub-opening OP1b communicates with the first sub-openings OP1a.

The plurality of wavelength conversion patterns WCP (for example, the red light wavelength conversion pattern WCP1 and the green light wavelength conversion pattern WCP2) are respectively disposed in the plurality of first sub-openings OP1a of the plurality of first openings OP1. It should be noted that a wavelength conversion module 200C also includes a plurality of light-transmitting patterns TP, and the light-transmitting patterns TP are respectively disposed in the plurality of second openings OP2. Therefore, a part of the excitation light beams LBe coming from the light source module 100 (i.e., the third part of the excitation light beams LBe coming from the light source module 100) may directly pass through the light-transmitting patterns TP to serve as the blue light for display. In the embodiment, a material of the light-transmitting pattern TP is, for example, a photoresist material or an optical adhesive material that allows the excitation light beam LBe to directly pass through, but the invention is not limited thereto. In other embodiments, the second openings OP2 of the isolation structure layer 210B may also be cavities without any components.

It should be noted that, in the embodiment, the wavelength conversion module 200C has a plurality of dichroic filter layers 230P, and the dichroic filter layers 230P are respectively disposed in the second sub-openings OP1b of the first openings OP1. Namely, the dichroic filter layers 230P are structurally separated from each other. Since functions of the wavelength conversion patterns WCP, the dichroic filter film 220 and the dichroic filter layers 230P of the display device 20 of the embodiment on the excitation light beams and the converted light beams are similar to the functions of the wavelength conversion patterns WCP, the dichroic filter film 220 and the dichroic filter layer 230 of the display device 10 of FIG.1 on the excitation light beams and the converted light beams, reference may be made to the related paragraphs of the aforementioned embodiments for detailed description, and detail thereof is not repeated.

The manufacturing method of the wavelength conversion module 200C is exemplarily described below. First, a plurality of dichroic filter layers 230P separated from each other are formed on the light-transmitting substrate 202, as shown in FIG.9A. Then, a plurality of wavelength conversion patterns WCP separated from each other are respectively formed on the dichroic filter layers 230P. For example, the step of forming the wavelength conversion patterns WCP may include forming a plurality of red light wavelength conversion patterns WCP1 and forming a plurality of green light wavelength conversion patterns WCP2, as shown in FIG.9B. It should be noted that the wavelength conversion patterns WCP are completely overlapped with the dichroic filter layers 230P in the normal direction of the surface 202s of the light-transmitting substrate 202.

After the step of forming the wavelength conversion patterns WCP is completed, a plurality of light-transmitting patterns TP are formed, as shown in FIG.9C. The light-transmitting patterns TP are arranged between the dichroic filter layers 230P, and are arranged at intervals from the dichroic filter layers 230P. More specifically, the plurality of wavelength conversion patterns and the light-transmitting patterns TP are arranged in alternation on the light-transmitting substrate 202 and are separated from each other. It should be noted that the invention does not limit a formation sequence of the light-transmitting patterns TP and the wavelength conversion patterns WCP. In other embodiments, the wavelength conversion patterns WCP may also be formed after the light-transmitting patterns TP are formed. For example, the steps of forming the dichroic filter layers 230P, the red light wavelength conversion patterns WCP1, the green light wavelength conversion patterns WCP2, and the light-transmitting patterns TP are, for example, general photolithographic etching steps, and details thereof are not repeated.

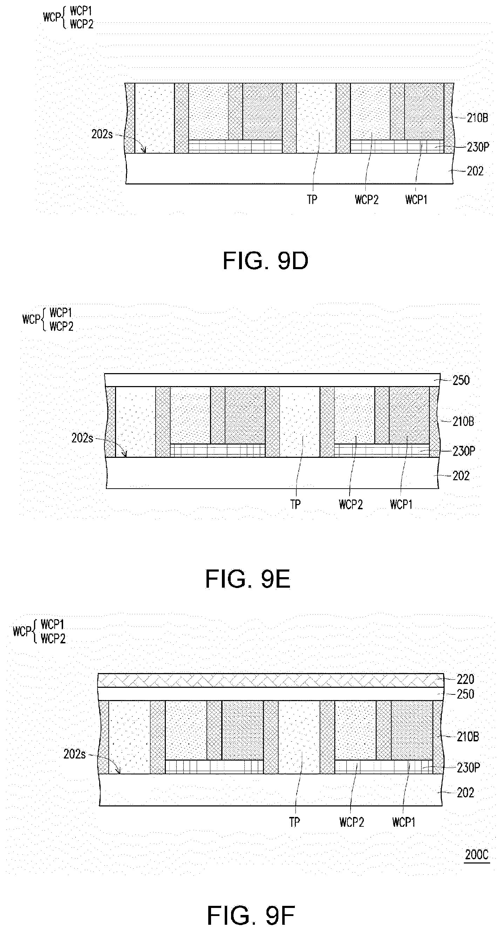

Referring to FIG.9D, an isolation structure layer 210B is formed in the gaps between the plurality of wavelength conversion patterns WCP and the plurality of light-transmitting patterns TP, and surfaces of the plurality of wavelength conversion patterns WCP, the plurality of light-transmitting patterns TP, and the isolation structure layer 210B are aligned with each other at one side away from the light-transmitting substrate 202. In the embodiment, the manufacturing method of the wavelength conversion module 200C may further include forming an intermediate layer 250 on the side of the isolation structure layer 210B away from the light-transmitting substrate 202 (as shown in FIG.9E ). A material of the intermediate layer 250 includes, for example, silicon dioxide (SiO₂), silicon nitride (SiNx), or other suitable dielectric layers. By selecting the material of the intermediate layer 250, the intermediate layer 250 may serve as a protective layer and a planarization layer. However, the invention is not limited thereto, and in other embodiments, the manufacturing method of the wavelength conversion module may not include the step of forming the intermediate layer 250. Referring to FIG.9F, after the step of forming the intermediate layer 250 is completed, the dichroic filter film 220 is formed on the intermediate layer 250. Namely, the intermediate layer 250 is located between the isolation structure layer 210B and the dichroic filter film 220. At this point, fabrication of the wavelength conversion module 200C is completed.

It should be noted that since the isolation structure layer 210B is formed after the plurality of dichroic filter layers 230P, the plurality of wavelength conversion patterns WCP, and the plurality of light-transmitting patterns TP are formed, the wavelength conversion patterns WCP (or the dichroic filter layer 230P) and the light-transmitting patterns TP arranged at intervals may be separated by the subsequently formed isolation structure layer 210B. In this way, the light output concentration of each display pixel region (i.e., the first opening OP1 or the second opening OP2) may be effectively improved, so as to improve the display quality (such as image clarity).

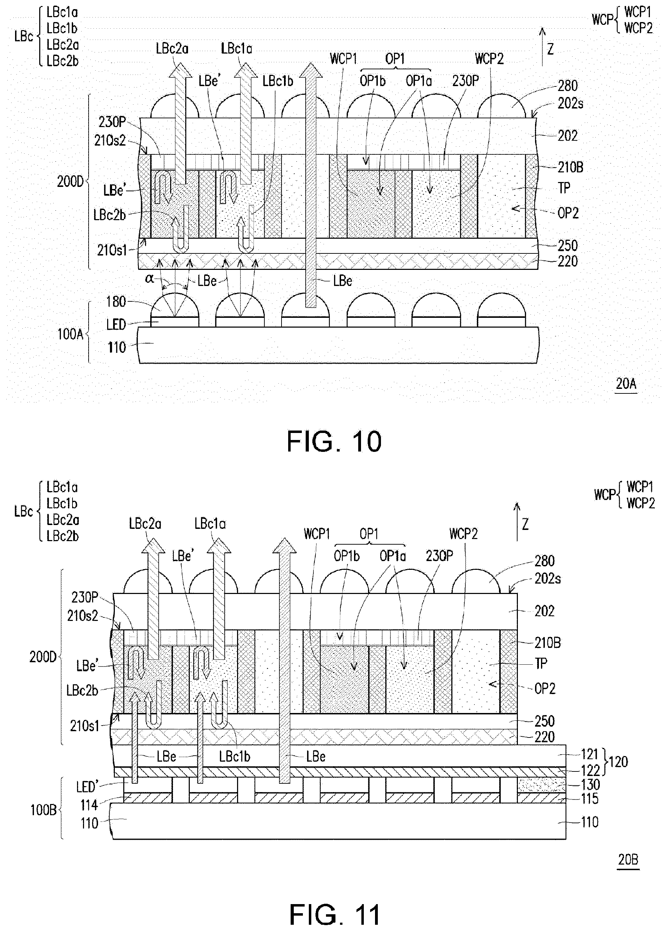

FIG. 10 is a schematic cross-sectional view of a part of a display device according to a fifth embodiment of the invention. Referring to FIG. 10, a difference between a display device 20A of the embodiment and the display device 20 of FIG.8 is that: a light source module 100A of the embodiment further includes a plurality of optical microstructures 180 respectively covering a plurality of the light-emitting diode elements LED, and located between the light-emitting diode elements LED and the dichroic filter film 220. Through the arrangement of the optical microstructures 180, a divergence angle α of the excitation light beams LBe emitted by the light-emitting diode elements LED after passing through the optical microstructures 180 may be reduced, and the divergence angle α is, for example, less than or equal to 60 degrees. In this way, the light output concentration of the light source module 100A may be improved.

On the other hand, a plurality of optical microstructures 280 are disposed on a side surface 202s of the light-transmitting substrate 202 of the wavelength conversion module 200D away from the isolation structure layer 210B, and the optical microstructures 280 are respectively overlapped with the plurality of wavelength conversion patterns WCP (for example, the red wavelength conversion patterns WCP1 and the green wavelength conversion pattern WCP2) and the plurality of light-transmitting patterns TP in a normal direction (for example, the direction Z) of the surface 202s. In this way, a divergence angle of the converted light beams coming from the first openings OP1 (such as the converted light beams LBc1a and the converted light beams LBc2a) and the excitation light beams LBe coming from the second openings OP2 after passing through the optical microstructures 280 may be reduced, which helps to improve the light output concentration of each display pixel region (i.e., the first sub-opening OP1a or the second opening OP2). In other words, the display quality (such as image clarity) of the display device 20A may be improved.

FIG.11 is a schematic cross-sectional view of a part of a display device according to a sixth embodiment of the invention. Referring to FIG.11, a main difference between a display device 20B of the embodiment and the display device 20A of FIG.10 lies in different structures of the light source module. In the embodiment, the display device 20B further includes a transparent conductive film 120, and a light source module 100B thereof does not have the plurality of optical microstructures 180 as shown in FIG.10. The transparent conductive film 120 includes a substrate material 121 and a conductive material layer 122. The conductive material layer 122 is disposed between the substrate material 121 and the light source module 100B.

In the embodiment, a plurality of conductive patterns 114 are disposed on the substrate 110 of the light source module 100B. A plurality of light-emitting diode elements LED' are disposed between the transparent conductive film 120 and the substrate 110, and respectively electrically connect one of the conductive patterns 114 to the conductive material layer 122 of the transparent conductive film 120. More specifically, the conductive material layer 122 of the transparent conductive film 120 may serve as a common electrode layer of the light-emitting diode elements LED'. On the other hand, the substrate 110 of the light source module 100B is further provided with a connection element 115, and a conductive adhesive 130 is disposed between the transparent conductive film 120 and the substrate 110 to electrically connect the conductive material layer 122 of the transparent conductive film 120 and the connection element 115.

It should be noted that since the transparent conductive film 120 has the substrate material 121, the wavelength conversion module 200D may be attached to a side surface of the substrate material 121 facing away from the conductive material layer 122, but the invention is not limited thereto.

In summary, in the wavelength conversion module and the display device of an embodiment of the invention, the dichroic filter layer disposed on one side of the wavelength conversion patterns is used to reflect the excitation light beam passing through the wavelength conversion patterns back to the wavelength conversion patterns, and the dichroic filter film disposed on the other side of the wavelength conversion patterns is used to reflect the converted light beams coming from the wavelength conversion patterns back to the wavelength conversion patterns. In this way, the light output efficiency and conversion efficiency of the wavelength conversion module are improved. In addition, the permeability of the dichroic filter layer to the converted light beams and the reflectivity thereof to the excitation light beams may also effectively improve a color purity of display colors of the display device. In the manufacturing method of the wavelength conversion module of an embodiment of the invention, the isolation structure layer is formed after formation of the wavelength conversion patterns, the dichroic filter layer and the light-transmitting patterns. Therefore, the wavelength conversion patterns (or the dichroic filter layers) and the light-transmitting patterns arranged at intervals may be separated by the subsequently formed isolation structure layer, thereby improving light output concentration of each opening and the display quality (such as image clarity) of the display device.

It will be apparent to those skilled in the art that various modifications and variations can be made to the disclosed embodiments without departing from the scope of the invention. In view of the foregoing, it is intended that the invention covers modifications and variations provided they fall within the scope of the following claims and their equivalents. Moreover, any embodiment of or the claims of the invention is unnecessary to implement all advantages or features disclosed by the invention. Moreover, the abstract and the name of the invention are only used to assist patent searching. Moreover, "first", "second", etc. mentioned in the specification and the claims are merely used to name the elements and should not be regarded as limiting the upper or lower bound of the number of the components/devices.

The foregoing description of the preferred embodiments of the invention is presented for purposes of illustration and description. It's not intended to be exhaustive or to limit the invention to the precise form or to exemplary embodiments disclosed. Thus, the foregoing description should be regarded as illustrative rather than restrictive. Obviously, many modifications and variations will be apparent to practitioners skilled in this art. The embodiments are chosen and described in order to best explain the principles of the invention and its best mode practical application, thereby to enable persons skilled in the art to understand the invention for various embodiments and with various modifications as are suited to the particular use or implementation contemplated. It is intended that the scope of the invention be defined by the claims appended hereto and their equivalents in which all terms are meant in their broadest reasonable sense unless otherwise indicated. Therefore, the term "the invention", "the present invention" or the like does not necessarily limit the claim scope to a specific embodiment, and the reference to particularly preferred exemplary embodiments of the invention does not imply a limitation on the invention, and no such limitation is to be inferred. The invention is limited only by the scope of the appended claims. The abstract of the disclosure is provided to comply with the rules requiring an abstract, which will allow a searcher to quickly ascertain the subject matter of the technical disclosure of any patent issued from this disclosure. It is submitted with the understanding that it will not be used to interpret, limit the scope or meaning of the claims. Any advantages and benefits described may not apply to all embodiments of the invention. It should be appreciated that variations may be made in the embodiments described by persons skilled in the art without departing from the scope of the invention as defined by the following claims. Moreover, no element and component in the disclosure is intended to be dedicated to the public regardless of whether the element or component is explicitly recited in the following claims.

## Claims

1. A wavelength conversion module, comprising an isolation structure layer (210), a plurality of wavelength conversion patterns (WCP), a dichroic filter film (220), and at least one dichroic filter layer (230), wherein:
the isolation structure layer (210) comprises a first surface (210s1) and a second surface (210s2) opposite to each other, and a plurality of openings (OP) penetrating the first surface (201s1) and the second surface (210s2);
the wavelength conversion patterns (WCP) are respectively disposed in a part of the openings (OP), the wavelength conversion patterns (WCP) are configured to absorb a first part of a plurality of excitation light beams (LBe) and be excited to generate a plurality of converted light beams (LBc);
the dichroic filter film (220) is disposed on a side of the first surface (210s1) of the isolation structure layer (210) and is overlapped with the wavelength conversion patterns (WCP); and
the at least one dichroic filter layer (230) is disposed on a side of the second surface (210s2) of the isolation structure layer (210) or disposed in the openings (OP), and is overlapped with the wavelength conversion patterns (WCP), wherein a part of the converted light beams (LBc) are reflected back to the wavelength conversion patterns (WCP) by the dichroic filter film (220), and a second part of the excitation light beams (LBe) passing through the wavelength conversion patterns (WCP) are reflected back to the wavelength conversion patterns (WCP) by the at least one dichroic filter layer (230).

2. The wavelength conversion module as claimed in claim 1, wherein a number of the at least one dichroic filter layer (230) is one, the dichroic filter layer (230) is disposed on the side of the second surface (210s2) of the isolation structure layer (210), and the wavelength conversion module (200) further comprises a plurality of light-transmitting patterns (TP), the light-transmitting patterns (TP) are respectively disposed in another part of the openings (OP), the dichroic filter layer (230) comprises a light-transmitting region (TR) overlapped with the light-transmitting patterns (TP), and a third part of the excitation light beams (LBe) passing through the light-transmitting patterns (TP) directly pass through the light-transmitting region (TR) of the dichroic filter layer (230).

3. The wavelength conversion module as claimed in claim 1 or 2, further comprising a blocking layer (240), disposed between the dichroic filter layer (230) and the isolation structure layer (210), and directly contacting the wavelength conversion patterns (WCP) and the dichroic filter layer (230).

4. The wavelength conversion module as claimed in claim 1, 2 or 3, further comprising:
a light-transmitting substrate (201), disposed between the wavelength conversion patterns (WCP) and the dichroic filter layer (230); and/or
an adhesive layer (205), connecting the light-transmitting substrate (201) and the second surface (210s2) of the isolation structure layer (210).

5. The wavelength conversion module as claimed in claim 1, wherein the openings (OP) comprise a plurality of first openings (OP1) and a plurality of second openings (OP2), the first openings (OP1) and the second openings (OP2) are arranged in alternation, each of the first openings (OP1) comprises a plurality of first sub-openings (OP1a) located on the first surface (201s1) and a second sub-opening (OP1b) located on the second surface (210s2), the second sub-opening (OP1b) communicates with the first sub-openings (OP1a), and the wavelength conversion patterns (WCP) are respectively disposed in the first sub-openings (OP1a), the wavelength conversion module (200) further comprises a plurality of light-transmitting patterns (TP), the light-transmitting patterns (TP) are respectively disposed in the second openings (OP2) and configured to allow a third part of the excitation light beams (LBe) to pass through, a number of the at least one dichroic filter layer (230) is plural, and the dichroic filter layers (230) are respectively disposed in the second sub-openings (OP1b) of the first openings (OP1).

6. The wavelength conversion module as claimed in any one of the preceding claims, wherein a wavelength of the part of the converted light beams (LBc) reflected by the dichroic filter film (220) is between 475 nm and 700 nm and/or a wavelength of the second part of the excitation light beams (LBe) reflected by the at least one dichroic filter layer (230) is less than 500 nm.

7. The wavelength conversion module as claimed in any one of the preceding claims, wherein after the excitation light beams (LBe) pass through the dichroic filter film (220), a divergence angle of the excitation light beams (LBe) is changed from a first angle to a second angle, and the second angle is smaller than the first angle, preferably the second angle is smaller than or equal to 90 degrees.

8. The wavelength conversion module as claimed in any one of the preceding claims, wherein a material of the isolation structure layer (210) comprises a light-absorbing material, a metal material with high reflectivity, or a non-metal material with high reflectivity.

9. The wavelength conversion module as claimed in any one of the preceding claims, further comprising:
a light-transmitting substrate (201), disposed on the side of the second surface (201s2) of the isolation structure layer (210); and/or
a plurality of optical microstructures (180), disposed on a side surface of the light-transmitting substrate (201) that is away from the isolation structure layer (210), wherein the wavelength conversion patterns (WCP) are overlapped with the optical microstructures (180).

10. A manufacturing method of a wavelength conversion module, comprising:
forming a plurality of dichroic filter layers (230) separated from each other on a light-transmitting substrate (201);
forming a plurality of wavelength conversion patterns (WCP) separated from each other, wherein the wavelength conversion patterns (WCP) are completely overlapped with the dichroic filter layers (230);
forming a plurality of light-transmitting patterns (TP), wherein the wavelength conversion patterns (WCP) and the light-transmitting patterns (TP) are arranged in alternation and separated from each other; and
forming an isolation structure layer (210) between the light-transmitting patterns (TP) and the wavelength conversion patterns (WCP).

11. The manufacturing method of the wavelength conversion module as claimed in claim 10, further comprising forming a dichroic filter film (220), wherein the dichroic filter film (220) is located on a side of the isolation structure layer (210) that is away from the light-transmitting substrate (201).

12. The manufacturing method of the wavelength conversion module as claimed in claim 10 or 11, further comprising forming an intermediate layer (250) on the side of the isolation structure layer (210) that is away from the light-transmitting substrate (201), wherein the intermediate layer (250) is located between the isolation structure layer (210) and the dichroic filter film (220).

13. A display device, comprising a light source module, wherein the light source module (100) comprises a substrate (110), a plurality of light-emitting diode elements (LED), and a wavelength conversion module (200), wherein:
the light-emitting diode elements (LED) are disposed on the substrate (110), and are configured to provide a plurality of excitation light beams (LBe); and
the wavelength conversion module (200) is overlapped and arranged on the light source module (100), and comprises an isolation structure layer (210), a plurality of wavelength conversion patterns (200), a dichroic filter film (220), and at least one dichroic filter layer (230), wherein:
the isolation structure layer (210) comprises a first surface (210s1) and a second surface (210s2) opposite to each other, and a plurality of openings (OP) penetrating the first surface (210s1) and the second surface (210s2), and the light-emitting diode elements (LED) are respectively overlapped with the openings (OP);
the wavelength conversion patterns (WCP) are respectively disposed in a part of the openings (OP), the wavelength conversion patterns (WCP) are configured to absorb a first part of the excitation light beams (LBe) and be excited to generate a plurality of converted light beams (LBc);
the dichroic filter film (220) is disposed on a side of the first surface (210s1) of the isolation structure layer (210) and is overlapped with the wavelength conversion patterns (WCP); and
the at least one dichroic filter layer (230) is disposed on a side of the second surface (210s2) of the isolation structure layer (210) or disposed in the openings (OP), and is overlapped with the wavelength conversion patterns (WCP), wherein a part of the converted light beams (LBc) are reflected back to the wavelength conversion patterns (WCP) by the dichroic filter film (220), and a second part of the excitation light beams (LBe) passing through the wavelength conversion patterns (WCP) are reflected back to the wavelength conversion patterns (WCP) by the at least one dichroic filter layer (230).

14. The display device as claimed in claim 13, further comprising a transparent conductive film (120), comprising a substrate material (121) and a conductive material layer (122), wherein the conductive material layer (122) is disposed between the substrate material (121) and the light source module (100), and/or the substrate (110) of the light source module (100) is configured with a plurality of conductive patterns (114), the light-emitting diode elements (LED) are respectively electrically connected between one of the conductive patterns (114) and the conductive material layer (122), and the wavelength conversion module (200) is attached to the substrate material (121) of the transparent conductive film (120).

15. The display device as claimed in claim 13 or 14, wherein the light source module (100) further comprises a plurality of optical microstructures (180), respectively covering the light-emitting diode elements (LED) and located between the light-emitting diode elements (LED) and the dichroic filter film (220), preferably a divergence angle of the excitation light beams (LBe) after passing through the optical microstructures (180) is less than or equal to 60 degrees.
